(19) Europäisches Patentamt / European Patent Office / Office européen des brevets

(11) **EP 3 336 572 B1**

(12) **EUROPÄISCHE PATENTSCHRIFT**

(45) Veröffentlichungstag und Bekanntmachung des Hinweises auf die Patenterteilung:
**23.09.2020 Patentblatt 2020/39**

(51) Int Cl.:
*G01R 33/56* *(2006.01)* *G01R 33/563* *(2006.01)*

(21) Anmeldenummer: **17167484.9**

(22) Anmeldetag: **21.04.2017**

(54) **BESTIMMUNG VON DIFFUSIONSPARAMETERN MITTELS EINES VERGLEICHS VON MAGNETRESONANZMESSUNGEN MIT BERECHNETEN DATENSÄTZEN**

DETERMINATION OF DIFFUSION PARAMETERS VIA A COMPARISON OF MAGNETIC RESONANCE MEASUREMENTS WITH CALCULATED DATASETS

DÉTERMINATION DE PARAMÈTRES DE DIFFUSION UTILISANT UNE COMPARAISON DES MESURES À RÉSONANCE MAGNÉTIQUE AVEC DES ENSEMBLES DE DONNÉES CALCULÉS

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**20.06.2018 Patentblatt 2018/25**

(73) Patentinhaber: **Siemens Healthcare GmbH 91052 Erlangen (DE)**

(72) Erfinder:
• **Feiweier, Thorsten 91099 Poxdorf (DE)**
• **Huwer, Stefan 91056 Erlangen (DE)**

(56) Entgegenhaltungen:
**US-A1- 2015 301 142**

• YUN JIANG ET AL.: "Simultaneous T1, T2 and Diffusion Quantification using Multiple Contrast Prepared Magnetic Resonance Fingerprinting", PROCEEDINGS OF THE INTERNATIONAL SOCIETY FOR MAGNETIC RESONANCE IN MEDICINE, ISMRM, 25TH ANNUAL MEETING AND EXHIBITION, HONOLULU, HI, USA, 22 APRIL - 27 APRIL 2017, Nr. 1171, 7. April 2017 (2017-04-07), XP040688739,

• KEN SAKAIE: "Feasibility of Diffusion Tensor Imaging with Magnetic Resonance Fingerprinting", PROCEEDINGS OF THE INTERNATIONAL SOCIETY FOR MAGNETIC RESONANCE IN MEDICINE, ISMRM, 25TH ANNUAL MEETING AND EXHIBITION, HONOLULU, HI, USA, 22 APRIL - 27 APRIL 2017, Nr. 2557, 28. April 2014 (2014-04-28), XP040663626,

• Simone Coppo ET AL.: "Overview of Magnetic Resonance Fingerprinting", , 1. Februar 2016 (2016-02-01), XP055380755, Gefunden im Internet: URL:http://clinical-mri.com/wp-content/upl oads/2016/04/Gulani_MRF_MAGNETOM_Flash_I SM RM_2016.pdf [gefunden am 2017-06-12]

• ERIC Y. PIERRE ET AL.: "Multiscale reconstruction for MR fingerprinting : Multiscale Reconstruction for MR Fingerprinting", MAGNETIC RESONANCE IN MEDICINE., Bd. 75, Nr. 6, 30. Juni 2015 (2015-06-30), Seiten 2481-2492, XP055413397, US ISSN: 0740-3194, DOI: 10.1002/mrm.25776

• YANIV ASSAF ET AL: "Diffusion Tensor Imaging (DTI)-based White Matter Mapping in Brain Research: A Review", JOURNAL OF MOLECULAR NEUROSCIENCE :, HUMANA PRESS INC, Bd. 34, Nr. 1, 27. September 2007 (2007-09-27), Seiten 51-61, XP007919270, DOI: 10.1007/S12031-007-0029-0 [gefunden am 2007-09-27]

- **BASSER P J ET AL: "Diffusion-tensor MRI: Theory, experimental design and data analysis - A technical review", NMR IN BIOMEDIC, WILEY, LONDON, GB, Bd. 15, Nr. 7-8, 1. November 2002 (2002-11-01), Seiten 456-467, XP007918925, ISSN: 0952-3480, DOI: 10.1002NBM.783**

**Beschreibung**

Die vorliegende Erfindung betrifft ein Verfahren zur Bestimmung von zumindest einem Diffusionsparameter bei einer Untersuchungsperson gemäß Anspruch 1 und die zugehörige MR-Anlage gemäß Anspruch 10. Die Erfindung betrifft weiterhin ein Computerprogrammprodukt mit Programmmitteln gemäß Anspruch 12 und einen elektronisch lesbaren Datenträger gemäß Anspruch 13.

In Yun Jiang et al.: "Simultaneous TI, T2 and Diffusion Quantification using Multiple Contrast Prepared Magnetic Resonance Fingerprinting", PROCEEDINGS OF THE INTERNATIONAL SOCIETY FOR MAGNETIC RESONANCE IN MEDICINE, ISMRM, 25TH ANNUAL MEETING AND EXHIBITION, HONOLULU, HI, USA, 22 APRIL - 27 APRIL 2017, Seite 1171, 7. April 2017, ist ein Magnetresonanzbildgebungsverfahren zur Ermittlung eines Diffusionsparameters offenbart, wobei mit unterschiedlichen Parametern durchgeführte Messungen mit vorabberechneten Datensätzen verglichen werden, um den Diffusionsparameter zu ermitteln. Der zugehörige Rohdatenraum ist hierbei bezogen auf die einzelnen Diffusionsmessungen unterabgetastet.

In Peter J. Basser et al.: "Diffusion-tensor MRI: Theory, experimental design and data analysis - A technical review", NMR IN BIOMEDICINE, WILEY, LONDON, GB, Bd. 15, Nr. 7-8, 1. November 2002, Seiten 456-467, ist ein Magnetresonanzverfahren zur Ermittlung eines Diffusionsparameters offenbart, wobei mehrere Messungen mit unterschiedlichen Parametern durchgeführt werden, wobei der Diffusionsparameter über lineare Regression ermittelt wird.

Die MR-Diffusionsbildgebung stellt bei der Beantwortung neurologischer und onkologischer Fragestellungen ein wichtiges diagnostisches Hilfsmittel dar. Auch in anderen klinischen Gebieten, wie beispielsweise der Orthopädie oder der Kardiologie, nimmt die Bedeutung der MR-Diffusionsbildgebung stetig zu. In der Regel befundet der Radiologe dabei nicht die diffusionsgewichteten Ausgangsbilder, sondern abgeleitete Bilder oder Karten wie beispielsweise Trace-Bilder, ADC-Karten (Karten des scheinbaren Diffusionskoeffizienten) oder Karten die die fraktionelle Anisotropie darstellen, sogenannte FA-Karten. Diesen abgeleiteten Darstellungen liegen in der Regel Modelle des Diffusionsprozesses zu Grunde: Bei einer angenommenen freien Diffusion zerfällt beispielsweise das Signal bei Verwendung eines gaußförmigen Operators als Funktion der Diffusionswichtung, des b-Wertes gemäß der Formel $S(b) = M_0 \exp(-b \, ADC)$. $M_0$ stellt hierbei das Signal ohne Diffusionswichtung das heißt mit b = 0 dar.

Zur Bestimmung der abgeleiteten Darstellungen bzw. der abgeleiteten Diffusionsparameter wird oft eine Modellfunktion an die aufgenommenen Daten angepasst. Hierbei werden beispielsweise mithilfe einer nicht-linearen Regression die Modellparameter derart bestimmt, dass eine Kostenfunktion, wie beispielsweise die Summe der Residuen von Messwerten und Modellfunktion minimiert wird.

Mit steigender Komplexität der Modelle nimmt jedoch die Wahrscheinlichkeit zu, dass diese Regressionsverfahren nicht das gesuchte globale Minimum der Kostenfunktion finden, stattdessen liefert das Verfahren häufig suboptimale Resultate, die lediglich ein lokales Minimum darstellen.

Es ist daher eine Aufgabe der vorliegenden Erfindung, die Berechnung der Diffusionsparameter derart zu verbessern, dass sichergestellt wird, dass die richtigen Diffusionsparameter berechnet werden und die Modellparameter bzw. Diffusionsparameter identifiziert werden, die zu einer global optimierten Übereinstimmung mit den gemessenen MR-Signalen führen.

Diese Aufgabe wird durch die Merkmale der unabhängigen Ansprüche gelöst. Weitere Ausführungsformen sind in den abhängigen Ansprüchen beschrieben.

Gemäß einem ersten Aspekt wird ein Verfahren zur Bestimmung von zumindest einem Diffusionsparameter bei einer Untersuchungsperson mit Verwendung von MR-Signalen bereitgestellt, wobei MR-Signale in mehreren Diffusionsmessungen aufgenommen werden, wobei jede Diffusionsmessung mit einem definierten Satz von MR-Parametern gemessen wird und wobei sich die mehreren Diffusionsmessungen untereinander in zumindest einem MR-Parameter unterscheiden. Dies führt zu einem gemessenen MR-Signaldatensatz, in dem die MR-Signale für die unterschiedlichen verwendeten MR-Parameter gespeichert sind. Dies bedeutet, dass bei jeder Diffusionsmessung zumindest einer der MR-Parameter des Satzes geändert wurde, wobei in den verschiedenen Diffusionsmessungen keine gleichen Sätze von MR-Parametern verwendet werden. Weiterhin wird eine Vielzahl von berechneten Datensätzen bestimmt anhand eines Modells, wobei das Modell die Entwicklung der MR-Signale für die durchgeführten Diffusionsmessungen beschreibt und wobei für alle berechneten Datensätze eine definierte Anzahl von verschiedenen Modellparametern verwendet wird.

Für jede Kombination der verschiedenen Modellparameter und für verschiedene Werte der Modellparameter wird eine MR-Signalintensität für die Diffusionsmessungen berechnet. Diese berechneten Datensätze können entweder vorab berechnet werden und in einer Nachschlagetabelle gespeichert werden, oder sie werden insbesondere für einfache Modelle für die jeweilige Diffusionsmessung bei Verwendung des Verfahrens berechnet. Anschließend wird der gemessene MR-Signaldatensatz mit der Vielzahl der berechneten Datensätze verglichen zur Identifizierung desjenigen berechneten Datensatzes, der auf Grundlage eines Gütekriteriums die größte Übereinstimmung mit dem gemessenen MR-Signaldatensatz aufweist. Schließlich kann der zumindest eine Diffusionsparameter bestimmt werden anhand des berechneten Datensatzes mit der größten Übereinstimmung, wobei der zumindest eine Diffusionsparameter aus dem Modellparametern bestimmt wird, die bei der Bestimmung des berechneten Datensatzes mit der größten Übereinstim-

mung verwendet wurden.

Das erfindugsgemäße Verfahren verwendet ein Mustererkennungsverfahren, das anstelle eines Regressionsverfahrens eine extensive Suche verwendet. Aus der Sammlung der berechneten Datensätze wird derjenige Datensatz identifiziert, der die beste Übereinstimmung mit dem gemessenen MR-Signaldatensatz aufweist. Die diesen berechneten Datensatz zu Grunde liegenden Modellparameter stellen die gesuchten Resultate da. Die unterschiedlichen Sätze der MR Parameter bedeuten jedoch nicht, dass zur Signalerhöhung die Messung nicht mehrmals mit gleichen Parametern durchgeführt werden kann. Dies wir jedoch als ein Datensatz betrachtet.

Bei dem Verfahren werden aus den MR-Signalen mehrere MR-Diffusionsbilder erzeugt, bei denen die Signalintensität im zeitlichen Verlauf in einzelnen Bildpunkten der MR-Diffusionsbilder betrachtet werden zur Erstellung eines gemessenen MR-Signaldatenvektors für jeden Bildpunkt. Der gemessene MR-Signaldatenvektor weist dann die gemessenen Signalintensitäten für die unterschiedlichen verwendeten MR-Parameter auf, die bei den verschiedenen Diffusionsmessungen verwendet wurden. Wenn beispielsweise drei Diffusionsmessungen mit drei unterschiedlichen Diffusionswichtungen erzeugt wurden, so enthält der MR-Signaldatenvektor für jeden Bildpunkt oder für jede Kombination von Bildpunkten die jeweilige Signalintensitäten für die drei verschiedenen Diffusionswichtungen.

Wenn beispielsweise N Diffusionsmessungen durchgeführt werden mit N unterschiedlichen Sätzen der MR-Parameter, ist es möglich, für eine festgelegte Kombination der Modellparameter für die N Sätze der MR-Parameter die Signalintensität zu berechnen zur Erstellung von einem berechneten Datenvektor für diese festgelegte Kombination der Modellparameter und den verwendeten N Werten der MR-Parameter. Weiterhin wird der berechnete Datenvektor für alle möglichen Kombinationen der Werte der Modellparameter bestimmt, wodurch eine Vielzahl von unterschiedlichen berechneten Datenvektoren erzeugt werden. Jeder der berechneten Datenvektoren weist damit die MR-Signalintensitäten für N Diffusionsmessungen bei Verwendung der festgelegten Kombination der Modellparameter auf.
Es werden somit eine Vielzahl von berechneten Datenvektoren bestimmt. Diese Datenvektoren haben die gleiche Größe wie die gemessenen MR-Signaldatenvektoren, da der berechnete Datenvektor für eine festgelegte Kombination der Modellparameter die berechneten Signalwerte für die N Diffusionsmessungen aufweist.

Bei der Identifizierung desjenigen berechneten Datensatzes, der die größte Übereinstimmung mit dem gemessenen MR-Signaldatensatz aufweist, kann nun der gemessene MR-Signaldatenvektor mit der Vielzahl von unterschiedlichen berechneten Datenvektoren verglichen werden, wobei der berechnete Datenvektor identifiziert wird, der die größte Übereinstimmung mit dem gemessenen MR-Signalvektor hat.

Selbstverständlich ist der Vergleich zwischen den berechneten Datensätzen mit dem MR-Signaldatensatz nicht auf die Verwendung von Vektoren begrenzt. Es kann jede andere Möglichkeit verwendet werden, bei der die gemessenen Signalintensitäten für die N MR-Parametern mit der Summe der berechneten Datensätze verglichen wird.

Bei dem Vergleich ist es möglich, dass sowohl der gemessene MR-Signaldatensatz als auch die Vielzahl der berechneten Datensätze normiert werden vor dem Vergleich. Dadurch wird der Vergleich vereinfacht und für die Normierung kann beispielsweise die Magnetisierung $M_0$ verwendet werden, die der Magnetisierung ohne Diffusionswichtung entspricht.

Als unterschiedliche MR-Parameter können beispielsweise bei der Aufnahme der mehreren Diffusionsmessungen unterschiedliche Diffusionswichtungen verwendet werden, beispielsweise unterschiedliche b-Werte, wobei der b-Wert wie bekannt das Maß der Diffusionswichtung ist und von dem gyromagnetischen Verhältnis, der Gradientendauer und der Gradientenamplitude sowie der zeitlichen Länge des diffusionsgewichteten Gradienten abhängt.

Bei den verschiedenen Modellparametern, die verwendet werden zur Bestimmung der berechneten Datensätze, kann beispielsweise die Magnetisierung $M_0$ und eine vorbestimmte Anzahl von Werten der Magnetisierung $M_0$ verwendet werden, ein weiterer Modellparameter ist der apparente oder scheinbare Diffusionskoeffizient, ADC, wobei verschiedene Werte dieses apparenten Diffusionskoeffizienten im Modell angenommen werden. Eine weitere Möglichkeit besteht in der Verwendung des Diffusionstensors und der verschiedenen Werte dieses Tensors. Für jeden Wert des einzelnen Modellparameters wird dieser mit allen anderen Werten der anderen variierenden Modellparameter kombiniert, um alle möglichen Parameterkombinationen abzudecken. Hierbei ist es beispielsweise möglich, dass die eigentlichen Bildgebungsparameter wie die Echozeit TE, die Inversionszeit TI, Repetitionszeit TR etc. unverändert bleiben. Selbstverständlich ist es bei komplexeren Modellen jedoch auch möglich, diese Parameter zu verändern.

Wenn die Modellparameter den Diffusionstensor aufweisen, können beispielsweise bei Diffusionsmessungen zumindest drei verschiedene Diffusionsmessungen in unterschiedlichen Diffusionsrichtungen durchgeführt werden, die auf einander senkrecht stehen. Wenn mehr als drei Diffusionsrichtungen gemessen werden, Beispielseite 4, so sollten diese eine tetraedische Konfiguration aufweisen. Um zumindest die Spur des Diffusionstensors erfassen zu können müssen die Richtungen generell die folgende Bedingung erfüllen:

$$\Sigma_{n=1..N} \ \mathbf{b_n} = N/3 \ b \ \mathbf{1}$$

Wobei $\mathbf{b_n} = b \ \mathbf{g_i} \ \mathbf{g_i}^*$ die b-Matrix der Messung mit der Einheitsrichtung $\mathbf{g_i}$ ist, N die Anzahl der Messungen und $\mathbf{1}$ die

Einheitsmatrix repräsentiert. Beispielsweise findet man für die drei orthogonalen Richtungen
$g_1 = (1, 0, 0)$; $g_2 = (0, 1, 0)$; $g_3 = (0, 0, 1)$

$$\mathbf{b}_1 = b \begin{pmatrix} 1 & 0 & 0 \\ 0 & 0 & 0 \\ 0 & 0 & 0 \end{pmatrix}$$

$$\mathbf{b}_2 = b \begin{pmatrix} 0 & 0 & 0 \\ 0 & 1 & 0 \\ 0 & 0 & 0 \end{pmatrix}$$

$$\mathbf{b}_3 = \begin{pmatrix} 0 & 0 & 0 \\ 0 & 0 & 0 \\ 0 & 0 & 1 \end{pmatrix}$$

$$\sum_{n=1..3} \mathbf{b}_n = b \begin{pmatrix} 1 & 0 & 0 \\ 0 & 1 & 0 \\ 0 & 0 & 1 \end{pmatrix} = 3/3 * b * \mathbf{1}$$

Beispielsweise ist es möglich, die Magnetisierung $M_0$ und sechs Komponenten des Diffusionstensors als Modellparameter zu verwenden wobei für die Berechnung einer richtungsunabhängigen Diffusion dann bei dem Datensatz mit der größten Ähnlichkeit die Spur des Diffusionstensors verwendet werden kann zur Bestimmung einer mittleren richtungsunabhängigen Diffusion.

Es ist ebenfalls möglich eine richtungsabhängige Diffusion zu bestimmen mit Bestimmung eines richtungsabhängigen Diffusionstensors. Hierbei können beispielsweise die Magenetisierung $M_0$ und sechs Komponenten des Diffusionstensors als Modellparameter verwendet werden, wobei Diffusionsmessungen mit zumindest zwei verschiedenen Diffusionswichtungen und zumindest sechs verschiedenen Diffusionsrichtungen durchgeführt werden.

Außerdem wird bei der Diffusionsmessung der zugehörige Rohdatenraum gemäß der Nyquistbedingung vollständig mit Rohdaten gefüllt. Dies bedeutet, dass eine Rekonstruktion ohne Aliasing Artefakte möglich ist.

Die Erfindung betrifft weiterhin die zugehörige Magnetresonanzanlage, die eine Steuereinheit und eine Speichereinheit aufweist, wobei die Speichereinheit von der Steuereinheit ausführbare Steuerinformationen speichern kann. Die MR-Anlage ist ausgebildet, bei Ausführung der Steuerinformationen in der Steuereinheit die oben beschriebenen Schritte auszuführen.

Weiterhin ist ein Computerprogrammprodukt mit Programmmitteln vorgesehen, wobei das Computerprogrammprodukt direkt in eine Speichereinheit der Steuereinheit der MR-Anlage ladbar ist. Wenn die Programmmittel in der Steuereinrichtung ausgeführt werden die oben erläuterten Schritte durchgeführt. Weiterhin ist ein elektronisch lesbarer Datenträger mit den darauf gespeicherten Programmmitteln bzw. Steuerinformationen vorgesehen, wobei die Steuerinformationen ausgebildet sind, dass sie bei Verwendung des Datenträgers in der Steuereinheit der MR-Anlage das oben beschriebene Verfahren durchführen.

Die oben dargelegten Merkmale und die nachfolgend beschriebenen Merkmale können nicht nur in den entsprechenden explizit dargestellten Kombination verwendet werden, sondern auch in anderen Kombinationen soweit es nicht explizit anders erwähnt ist und dies unter den Gegenstand der Ansprüche fällt.

Die Erfindung wird nachfolgend unter Bezugnahme auf die beiliegenden Zeichnungen näher erläutert.

Figur 1 zeigt schematisch eine MR-Anlage mit der erfindungsgemäß Diffusionsparameter berechnet werden können.

Figur 2 zeigt schematisch wie durch einen Vergleich eines gemessenen MR-Signalvektors mit berechneten Datenvektoren derjenige Datenvektor mit der größten Ähnlichkeit bzw. mit der größten Übereinstimmung gefunden werden kann.

Figur 3 zeigt schematisch ein Beispiel für die gemessenen MR-Signaldatensätze und die berechneten Datensätze die aufgrund der Modellparameter berechnet wurden, wobei durch Vergleich dieser Daten ein gesuchter Diffusionsparameter bestimmt werden kann.

Figur 4 zeigt schematisch ein Flussdiagramm mit den Schritten zur Durchführung eines Verfahrens bei dem erfindungsgemäß der Diffusionsparameter bestimmt wird.

Nachfolgend wird die vorliegende Erfindung anhand bevorzugter Ausführungsformen unter Bezugnahme auf die Zeichnungen näher erläutert. In den Figuren bezeichnen gleiche Bezugszeichen gleiche oder ähnliche Elemente. Weiterhin sind die Figuren schematische Darstellungen verschiedener Ausführungsformen der Erfindung. Die in den Figuren dargestellten Elemente sind nicht notwendigerweise maßstabsgetreu dargestellt, sie sind vielmehr derart wiedergegeben, dass ihre Funktion und der Zweck für den Fachmann verständlich werden. Die in den Figuren dargestellten Verbindungen zwischen funktionellen Einheiten oder sonstigen Elementen können auch als indirekte Verbindung implementiert werden, als drahtlose oder drahtgebunde Verbindung. Funktionelle Einheiten können als Hardware, Software oder eine Kombination aus Hardware und Software implementiert werden.

Nachfolgend wird die Idee beschrieben, bei der anstelle eines Regressionsverfahrens eine extensive Suche verwendet wird. Für eine vorgegebene Diffusionsmessung wird auf Grundlage eines angenommenen Modells das Resultat der möglichen diffusionsgewichteten Signale für jede mögliche Kombination der Modellparameter berechnet. Aus dieser Sammlung der modellierten Daten wird derjenige berechnete Datensatz identifiziert, der die beste Übereinstimmung gemäß einem definierten Gütekriterium aufweist. Die diesen Datensatz zu Grunde liegenden Modellparameter bestimmen dann den gesuchten Diffusionsparameter. Zwar können die berechneten Datenmengen bei diesem Ansatz relativ groß werden, dies ist aber im Zeitalter der verfügbaren Rechenkapazität kein praktisches Problem mehr.

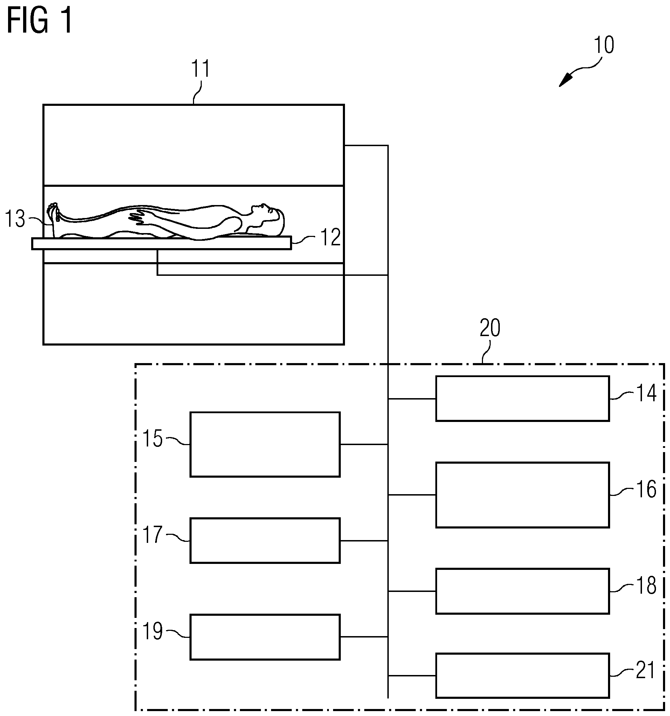

Die MR-Anlage, die hierfür verwendet werden kann ist in Figur 1 dargestellt.

Die MR-Anlage 10 weist einen Magneten 11 zur Erzeugung eines Polarisationsfeldes $B_0$ auf, wobei eine auf einer Liege 12 angeordnete Untersuchungsperson 13 in den Magneten 11 gefahren wird, um dort ortskodierte Magnetresonanzsignale im Zentrum des Magneten aus der Untersuchungsperson 13 aufzunehmen. Die zur Einstrahlung der HF-Pulse und zur Signalaufnahme verwendeten Spulen wie beispielsweise die Ganzkörperspule oder eine oder mehrere Lokalspulen sind aus Übersichtlichkeitsgründen nicht dargestellt. Die MR-Anlage kann für die parallele Bildgebung ausgebildet sein, bei der die MR-Signale gleichzeitig mit mehreren Lokalspulen, einem Spulenarray von Lokalspulen, detektiert werden. Durch Einstrahlen von Hochfrequenzpulsen und Schalten von Magnetfeldgradienten kann die durch das Polarisationsfeld $B_0$ erzeugte Magnetisierung aus der Gleichgewichtslage ausgelenkt und ortskodiert werden, und die sich ergebende Magnetisierung wird von den Empfangsspulen detektiert. Wie durch Einstrahlen der HF-Pulse und durch Schalten von Magnetfeldgradienten in verschiedenen Kombinationen und Reihenfolgen MR-Bilder erzeugt werden können, ist dem Fachmann grundsätzlich bekannt und wird hier nicht näher erläutert.

Die MR-Anlage 10 weist weiterhin eine Steuereinheit 20 auf, die zur Steuerung der MR-Anlage 10 verwendet werden kann. Die Steuereinheit 20 weist eine Gradientensteuereinheit 15 auf zur Steuerung und Schaltung der notwendigen Magnetfeldgradienten. Eine HF-Steuereinheit 14 ist für die Steuerungsgenerierung der HF-Pulse zur Auslegung der Magnetisierung vorgesehen. Eine Bildsequenzsteuerung 16 steuert die Abfolge der Magnetfeldgradienten, der HF-Pulse und der Signaldetektion und damit indirekt die Gradientensteuereinheit 15, die HF-Steuereinheit 14 und die nicht gezeigten Spulen. Über eine Eingabeeinheit 17 kann eine Bedienperson die MR-Anlage steuern und auf eine Anzeige 18 können MR-Bilder und sonstige zur Steuerung notwendigen Informationen angezeigt werden. Eine Recheneinheit 19 mit mindestens einer Prozessoreinheit ist vorgesehen zur Steuerung der verschiedenen Einheiten in der Steuereinheit 20. Insbesondere die Recheneinheit kann wie nachfolgend erläutert wird ausgebildet sein, um anhand von aufgenommenen MR-Signalen und berechneten Datensätzen einen Diffusionsparameters bestimmen, wie nachfolgend noch im Detail erläutert wird. Weiterhin ist eine Speicher 21 vorgesehen, der beispielsweise Programmmodule bzw. Programme abgespeichert sein können, die, wenn sie von der Recheneinheit bzw. ihren Prozessoren ausgeführt wird, den Ablauf der MR-Anlage steuern können.

Das Verfahren soll nun anhand einiger Beispiele erläutert werden, wobei die Komplexität der verschiedenen Beispiele später zunimmt.

<u>Erstes Beispiel</u>

In dem ersten Beispiel soll die richtungs-spezifische freie Diffusion als Diffusionsparameter bestimmt werden bei einer Untersuchungsperson, wobei die Diffusion entlang einer vorgegebenen Raumrichtung gemeint ist. Als Modellparameter für die zu berechneten Datensätze für die Signalsimulation der MR-Signale wird die Magnetisierung $M_0$ ohne Diffusionswichtung verwendet und der apparente Diffusionskoeffizient ADC. Hierfür werden Diffusionsmessungen mit mindestens zwei unterschiedlichen Diffusionswichtungen $b_1$, $b_2$,..., $b_N$ gemessen, bei denen alle anderen MR-Parameter wie die Diffusionsrichtung, die Echozeit oder Repetitionszeit unverändert bleiben. Dies bedeutet, dass die Diffusionsmessung mit einem definierten Satz von MR-Parametern gemessen wird, wobei sich von Messung zu Messung nur die Diffusionswichtung b ändert. Als Modell für die Entwicklung der MR-Signale wird folgende Gleichung 1 verwendet:

$$S_i' = M_0 \exp( -b_i ADC_R)) \quad (1)$$

Weiterhin werden eine Vielzahl von Datensätze berechnet, die zu jedem der b-Werte der Diffusionsmessungen, also insgesamt N Diffusionsmessungen, die erwartete Signalintensitäten $S_i'$ zeigt für die verschiedenen Werte der Modellparameter $M_0$ und ADC. Es können für die Magnetisierung $M_0$ beispielsweise die quantifizierten Werte 0,5, 10,..., 5000 verwendet werden und für ADC die Werte {0, 0.01, 0.02,..., 4.00} * 10-3 mm2/s. Dies ergibt für die Magnetisierung 1001 möglich Werte und für den Modellparameter ADC 401 mögliche Werte. Allgemein lässt sich sagen, dass für den ersten Modellparameter M1 X mögliche Werte angenommen werden und für den zweiten Modellparameter Y verschiedene Werte. Für jede Wertekombination wird nun die Signalintensität $S_i'$ für die N Diffusionsmessungen mit den N verschiedenen Diffusionswichtungen berechnet. Dies führt zu einer Matrix von X * Y Matrixkomponenten wobei jede Matrixkomponente als Signalvektor $S_i'$ gesehen werden kann mit $S_i'$ gleich ($S_1'$, $S_2'$, ..., $S_N'$). Jeder dieser Datenvektoren gibt an, welche Signalintensität für den Satz der N Messungen erwartet wird unter Annahme einer bestimmten Kombination der Modellparameter, hier eine Kombination der verschiedenen Werte der Magnetisierung $M_0$ und von ADC.

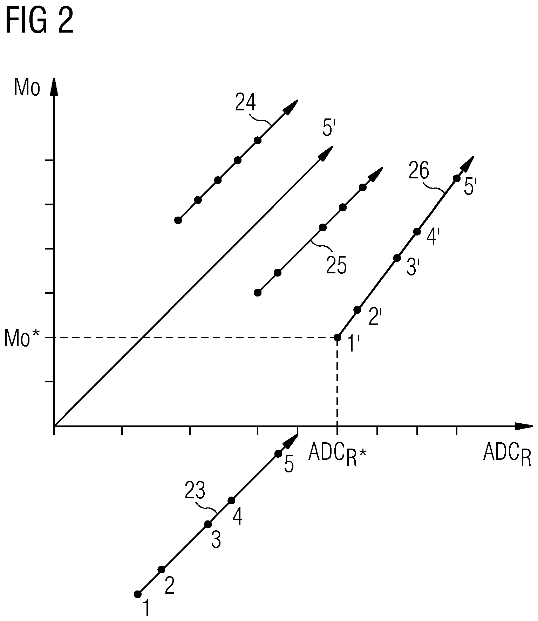

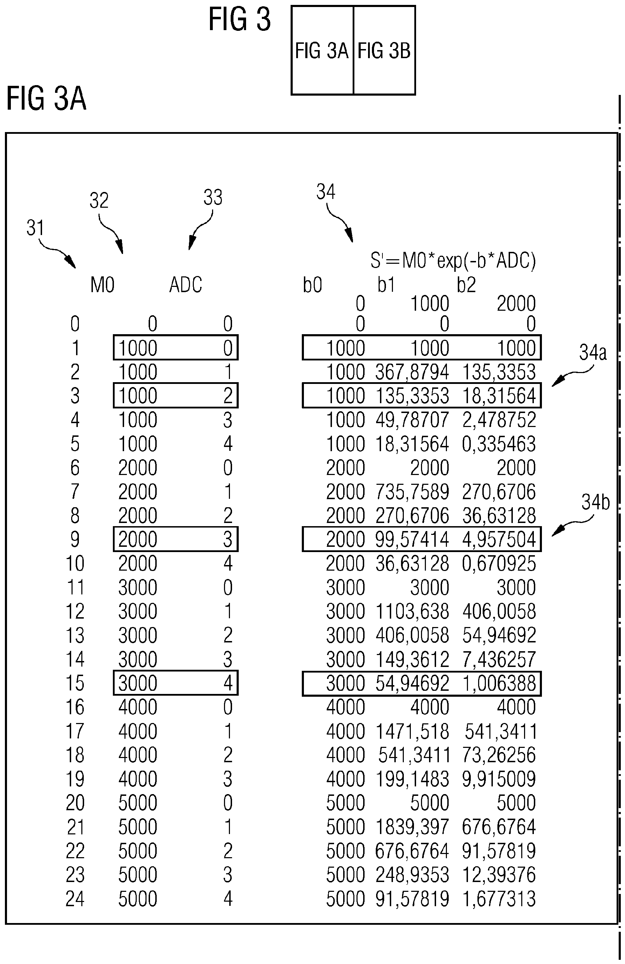

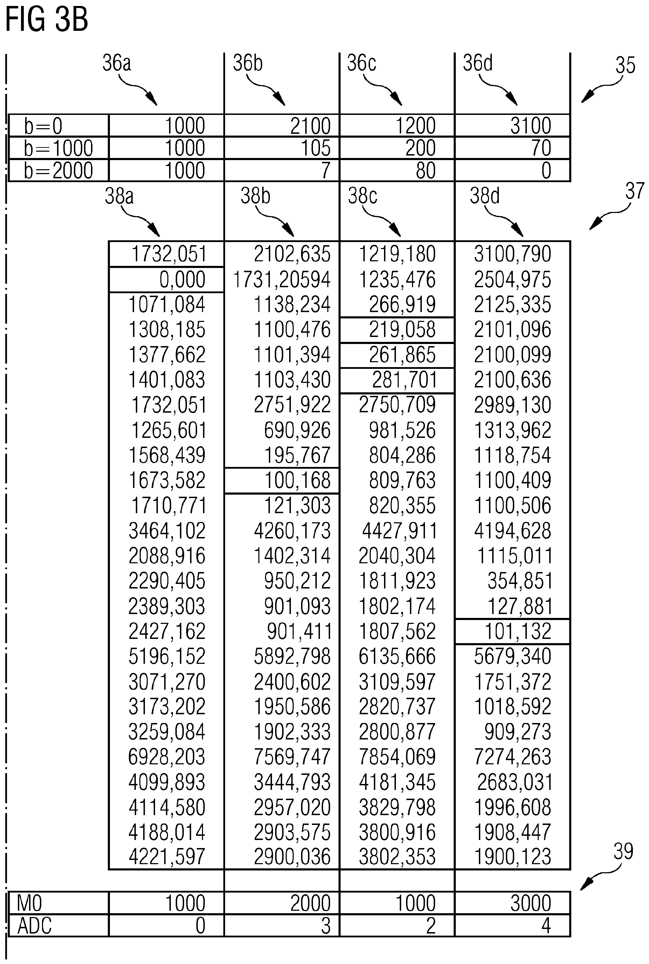

Dies wird beispielhaft in Zusammenhang mit Figur 2 und 3 näher erläutert.

Es wird angenommen, dass Diffusionsmessungen mit drei unterschiedlichen Diffusionswichtungen, d.h. drei unterschiedlichen b-Werten aufgenommen werden, der Signalverlauf ist hierbei wie in Gleichung 1 angegeben und es werden die b-Werte 0, 1000 und 2000 verwendet. Der sich ändernde MR-Parameter ist somit die Diffusionswichtung. Als Modellparameter werden hier die Magnetisierung $M_0$ und der apparente Diffusionskoeffizient ADC verwendet, wobei aus Übersichtlichkeitsgründen nur sehr grobe Raster verwendet werden wie die M0 Werte 0, 1000, 2000, 3000, 4000 und 5000. Als unterschiedliche ADC Werte werden die Werte 0, 1, 2, 3, 4 verwendet. Die möglichen Kombinationen der verschiedenen Modellparameter sind in Tabelle 31 in Figur 3 dargestellt, wobei in Spalte 32 die Werte der Magnetisierung angegeben sind und in Spalte 33 die möglichen verschiedenen Werte des apparenten Diffusionskoeffizienten. Für die verschiedenen Kombinationen der Modellparameter wird nun für die drei verschiedenen Diffusionswichtungen von 0, 1000 und 2000 das Signal berechnet wie es in Tabelle 34 angegeben ist. Dies führt zu den drei verschiedenen berechneten MR-Signalintensitäten pro Parameterkombination.

Im rechten Teil von Figur 3 ist nun, für verschiedene Messungen dargestellt, welche Signalintensitäten sich ergeben für die verschiedenen Diffusionswichtungen b = 0, 1000 und 2000. Dies führt zu Tabelle 35, wo die Signalintensitäten bei den Messungen aufgetragen sind. Die gemessenen Signalintensitäten können dann als gemessener MR-Signalvektor 36a, 36b, 36c und 36d angesehen werden, wobei im dargestellten Beispiel jeder Signalvektor drei Komponenten hat, beispielsweise der Signaldatenvektor 36c, die Intensitätswerte 1200, 200 und 80. Diese MR-Signaldatenvektoren 36a bis 36d können dann jeweils mit der Vielzahl der unterschiedlichen berechneten Signalintensitäten verglichen werden, wobei jede Zeile der Tabelle 34 ebenfalls als Vektor verstanden werden kann, beispielsweise der Datenvektor 34a oder der Datenvektor 34b. Die einzelnen Signalvektoren 36a bis d werden nun mit den einzelnen Zeilen der Tabelle 34 verglichen, um die größte Übereinstimmung bzw. die größte Ähnlichkeit zu bestimmen. Es erfolgt somit der Abgleich des gemessenen MR-Signaldatenvektors mit der Vielzahl der berechneten Datenvektoren, wobei die größte Einstimmung beispielsweise mit dem Maximum des inneren Produktes berechnet werden kann. Weiterhin ist es möglich, die größte Übereinstimmung mit der Bestimmung des euklidischen Abstandsmaßes zu bestimmen wie es in Tabelle 37 verwendet wurde. Die einzelnen Spalten 38a bis 38d zeigen jeweils die berechnete euklidische Distanz zwischen der zugehörigen Messung und jedem der Modellkombinationen aus Tabelle 34. Für den gemessenen MR-Signaldatenvektor 36b mit den Werten 2100, 105 und 7 ist die euklidische Distanz beispielsweise minimal für den Datenvektor 34b, was bedeutet, dass die zugehörige Magnetisierung M0, 2000 betrug und der apparente Diffusionskoeffizienten 3. Auf ähnliche Weise können nun die Werte von $M_0$ und ADC für die anderen Messungen bestimmt werden, die Ergebnisse sind jeweils in Tabelle 39 zusammengefasst.

Grafisch ist dieser Zusammenhang in Figur 2 gezeigt. Bei dem dort gezeigten Beispiel wird angenommen, dass fünf verschiedene Diffusionswichtungen, bzw. fünf verschiedene b-Werte verwendet wurden bei der Erstellung der MR-Diffusionsmessungen. Dies führt zu einem Datenvektor 23 mit fünf Komponenten, nämlich dem Signaldatenvektor. Dieser Signaldatenvektor kann mit dem Parameterraum verglichen werden, in dem die verschiedenen berechneten Datenvektoren liegen. Im dargestellten Beispiel waren dies wie in Figur 3 unterschiedliche Werte für die Magnetisierung $M_0$ und den Diffusionskoeffizienten ADC. Aus Übersichtlichkeitsgründen sind nur drei der berechneten Datenvektoren dargestellt, nämlich die Datenvektoren 24, 25 und 26. Selbstverständlich existiert dieser berechnete Datenvektor für jeden verwendeten quantifizierten Wert von $M_0$ und ADC. In die dritte Dimension, in die Zeichenebene hinein, ist dann die berechnete Signalintensität aufgetragen. Im dargestellten Fall entspricht der Signaldatenvektor 23 am ehesten dem berechneten Datenvektor 26, was sich grafisch aus der Reihenfolge der gemessenen Signalintensitäten ergibt. Die Datenpunkte 1-5 des MR-Signaldatenvektors entsprechend in ihrer Lage am ehesten den Datenpunkten $S_1'$ bis $S_5'$ des berechneten Datenvektors 26 die Modellparameter $M_0$ und ADC lassen sich dann auf den Achsen ablesen, hier die Werte $M_0$* und ADC*.Anders ausgedrückt kann man den fünf Punkten des MR-Signalvektors einen Helligkeitswert zuordnen (Signalamplitude), ebenso hätten alle Punkte der Datenvektoren die gemäß Modell berechneten Helligkeitswerte. Dann kann man denjenigen Vektor mit der besten Übereinstimmung identifizieren: die Lage des zugehörigen Datenvektors bestimmt dann die zugehörigen Modellparametern M0 und ADC.

Wie oben erläutert ist für die Berechnung der gewünschten Diffusionsparameter, hier des Differenzparameters ADC keine Regression notwendig. Die Suche über alle modellierten Datensätze bzw. berechneten Datenvektoren ergibt eindeutig das globale Optimum.

Zweites Beispiel

In einem zweiten Beispiel soll bestimmt werden, welche mittlere Diffusion in drei Dimensionen vorliegt, d.h. welche richtungsunabhängige freie Diffusion. Diese entspricht der Spur des Diffusionstensors. Als Modellparameter werden wiederum die Magnetisierung $M_0$ und sechs verschiedene Komponenten des Diffusionstensors verwendet. Als Diffusionsmessungen werden MR-Daten aufgenommen bei zumindest zwei unterschiedlichen Diffusionswichtungen $b_1$, $b_2$,..., $b_N$ und mindestens drei verschiedenen Diffusionsrichtungen $g_1$, $g_2$,..., $g_N$ für zumindest eine von null verschiedene Diffusionswichtung. Alle anderen Bildgebungsparameter wie Echozeit oder Repetitionszeit bleiben unverändert. Als Modell für die Entwicklung der MR-Signale wird folgende Gleichung verwendet:

$$S_i' = M_0 \exp( -\mathbf{B_i} : \mathbf{D}) \qquad (2)$$

$\mathbf{B_i}$ stellt hier b-Matrix der Messung mit Index i dar und D den Diffusionstensors. Das Tensor-Produkt B:D ist definiert mit folgender Gleichung:

$$\mathbf{B:D} = B_{xx} D_{xx} + B_{yy} D_{yy} + B_{zz} D_{zz} + 2 B_{xy} D_{xy} + 2 B_{xz} D_{xz} + 2 B_{yz} D^{yz} \qquad (3)$$

Die Auswahl der mindestens drei Diffusionsrichtungen kann hierbei derart erfolgen, dass die Bedingungen für Tracegewichtete Bilder erfüllt sind. Dies bedeutet, dass wenn für einen b-Wert beispielsweise drei Diffusionsrichtungen gemessen werden, so müssen diese orthogonal zu einander sein. Wenn vier verschiedene Richtung gemessen werden, so sollten diese eine tetraedische Konfiguration aufweisen.

Beispielsweise werden die zu jedem b-Wert der i = 1 ... N Messungen erwarteten Signalintensitäten Si' berechnet für $M_0 \in \{ 0, 5, 10, ..., 5000 \}$, $D_{xx}$, $D_{yy}$, $D_{zz}$, Dxy, $D_{xz}$, $D_{yz} \in \{ 0, 0.01, 0.02, ..., 4.00 \} * 10^{-3}$ mm2/s. Hierbei ist angenommen, dass sich bei der Messung der Wertebereich für $M_0$ von 0 bis 5000 erstreckt (1001 mögliche Werte) und derjenige für die Komponenten des Diffusionstensors von 0 bis 4 * 10-3 mm2/s (401 mögliche Werte).

Durch Abgleich des gemessenen Signaldatenvektors S = ($S_1$, $S_2$, ..., $S_N$) mit der Vielzahl simulierter Vektoren S' wird derjenige ermittelt, welcher die Messung am besten wiedergibt. Zu beachten ist, dass eine eindeutige Bestimmung aller Komponenten des Diffusionstensors mit beispielsweise nur drei gemessenen Richtungen nicht möglich ist: mehrere simulierte Signalvektoren können den gemessenen Signalintensitätsvektor identisch gut beschreiben. Bei geeigneter Wahl der Richtungen (wie oben beschrieben) ist aber sichergestellt, dass jeder dieser simulierten Signalvektoren einem Diffusionstensor mit identischer Spur zugeordnet ist: die Summe der Diagonalelemente Tr($\mathbf{D}$) = $D_{xx}$ + $D_{yy}$+ $D_{zz}$ ergibt gerade den gesuchten richtungsunabhängigen (mittleren) Diffusionskoeffizienten. Alternativ kann zunächst auch für jede aufgenommene Diffusionswichtung auf konventionelle Weise ein Trace-gewichtetes Bild berechnet werden, beispielsweise durch geometrische Mittelung gemäß

$$S_{TR}=\exp(1/M \, \Sigma \, \ln(S_m)), \qquad (4)$$

wobei die Summe über die M für den b-Wert aufgenommenen Richtungen läuft. Danach wird mit einer Modellierung analog zu Beispiel 1 gearbeitet.

Als Modellparameter werden wiederum die Magnetisierung $M_0$ und der ADC verwendet, wobei letzterer richtungsunabhängig ist. Als Diffusionsmessungen werden Messungen mit mindestens zwei unterschiedlichen Diffusionswichtungen und mindestens 3 dezidierten Diffusionsrichtungen durchgeführt, für die von 0 verschiedene Diffusionswichtungen verwendet werden, bei denen alle anderen Bildgebungsparameter bzw. Modellparameter unverändert bleiben. Die Modellierung der berechneten Datensätze erfolgt mit folgender Gleichung: Modellierung der Datenbasis:

$$S_{TR,i}` = M_0 \exp( -b \; ADC) \qquad (5)$$

Beispielsweise werden die zu jedem b-Wert der i = 1 ... N Messungen erwarteten Signalintensitäten $S_{TR,i}$' berechnet für $M_0 \in \{ 0, 5, 10, ..., 5000 \}$ und für $ADC \in \{ 0, 0.01, 0.02, ..., 4.00 \} * 10\text{-}9$ mm2/s. Hierbei ist angenommen, dass sich bei der Messung der Wertebereich für M0 von 0 bis 5000 erstreckt (1001 mögliche Werte) und derjenige für ADC von 0 bis 4 * 10-3 mm2/s (401 mögliche Werte). Durch Abgleich des gemessenen Signalintensitätsvektors STR = $(S_1, S_2, ..., S_N)$ mit der Vielzahl simulierter Vektoren STR' wird derjenige ermittelt, welcher die Messung am besten wiedergibt.

Drittes Beispiel

In dem nachfolgend erläuterten dritten Beispiel erfolgt eine freie Diffusion in drei Raumdimensionen wobei für die berechneten Datensätze die Modellparameter $M_0$ und sechs Komponenten des Diffusionstensors verwendet werden. Die Diffusionsmessungen erfolgen wieder mindestens mit zwei unterschiedlichen Diffusionswichtungen $b_1$ bis $b_N$ und mindestens sechs der zitierten Diffusionsrichtungen $g_1$ bis $g_N$ für zumindest eine der von null verschiedenen Diffusionswichtungen, wobei wiederum alle anderen Parameter unverändert bleiben. Als Modell für die Berechnung der Datensätze wird folgende Gleichung verwendet: Modellierung der Datenbasis:

$$S_i` = M_0 \exp( -\mathbf{B_i} : \mathbf{D}) \qquad (6)$$

$\mathbf{B_i}$ stellt hierbei die b-Matrix der Messung dar und $\mathbf{D}$ den Diffusionstensor. Das Tensor-Produkt $\mathbf{B{:}D}$ ist definiert als $\mathbf{B{:}D} = B_{xx} D_{xx} + B_{yy} D_{yy} + B_{zz} D_{zz} + 2 B_{xy} D_{xy} + 2 B_{xz} D_{xz} + 2 B_{yz} D_{yz}$. Die Auswahl der mindestens sechs Diffusionsrichtungen hat so zu erfolgen, dass die Bedingungen für eine Tensor-Bestimmung erfüllt sind. Beispielsweise werden die zu jedem b-Wert der i = 1 ... N Messungen erwarteten Signalintensitäten $S_i$' berechnet für $M_0$ { 0, 5, 10, 5000 }, $D_{xx}$, $D_{yy}$, $D_{zz}$, $D_{xy}$, $D_{xz}$, $D_{yz} \in \{ 0, 0.01, 0.02, ..., 4.00 \} * 10\text{-}9$ mm2/s. Hierbei ist angenommen, dass sich bei der Messung der Wertebereich für $M_0$ von 0 bis 5000 erstreckt (1001 mögliche Werte) und derjenige für die Komponenten des Diffusionstensors von 0 bis 4 * 10-3 mm2/s (401 mögliche Werte). Durch Abgleich des gemessenen Signaldatenvektors S = $(S_1, S_2, ..., S_N)$ mit der Vielzahl simulierter Vektoren S' wird derjenige ermittelt, welcher die Messung am besten wiedergibt. Im Gegensatz zu Beispiel 2 erlauben die mindestens sechs nicht-kollinearen Richtungen für mindestens einen von Null verschiedenen b-Wert die Bestimmung aller Tensor-Komponenten. Aus dem derart bestimmten Diffusionstensor lassen sich abgeleitete Parameterkarten wie ADC, FA, ... in gewohnter Weise berechnen.

Die oben beschriebene Vorgehensweise lässt sich auf komplexere Modelle mit weiteren Modellparametern erweitern. Hierbei können Tensormodelle höherer Ordnung verwendet werden, beispielsweise Diffusions-Kurtosis. Weiterhin können Multitensormodelle verwendet werden oder mikroskopische Fasermodelle bzw. Multikomponentenmodelle. Ebenso ist es möglich Mikrostrukturmodelle zu verwenden Wenn eine größere Anzahl von Modellparametern verwendet wird, so erfordert dies in der Regel eine größere Anzahl von Diffusionsmessungen, beispielsweise mit weiteren Diffusionsrichtungen und/oder Diffusionsrichtungen. Mikrostrukturmodelle können darüber hinaus die Variationen weiterer experimentelle Parameter und die Berücksichtigung dieser Parameter in der Modellierung erforderlich machen. Beispielsweise kann eine Variation des Zeitablaufs der Diffusionskodierung erforderlich werden wie beispielsweise die Kodierungszeit oder Evolutionszeit.

In den zuvor beschriebenen Modellen wurden Messungen dahingehend eingeschränkt, dass "alle anderen Parameter (TE, TR, ... " unverändert bleiben. Sofern sich der Einfluss weiterer Parameter auf die Signalintensität modellieren lässt, kann das Modell entsprechend erweitert und die Einschränkungen reduziert werden. Ändert sich beispielsweise die Echozeit TE (bei konstantem TR), erfährt die gemessene Signalintensität eine entsprechende Variation gemäß der T2-Relaxation. Dem kann durch Erweiterung der Modellierung um einen Faktor exp(-TE/T2) Rechnung getragen werden. Auf diese Weise ist es beispielsweise möglich, jede Einzelmessung mit der für den gewählten b-Wert minimal möglichen Echozeit durchzuführen, und auf diese Weise das SNR zu maximieren. Große b-Werte erfordern stärkere und längere Diffusions-Kodierungsgradienten als kleinere b-Werte: für letztere kann somit ein kürzeres TE genügen. Eine Variation der Repetitionszeit TR führt zu Modulationen in der zu Beginn einer Messung verfügbaren Longitudinalmagnetisierung. Die Modellierung, bei der die T1-Relaxationszeit eine Rolle spielt, ist zwar komplexer, bleibt aber - beispielsweise unter Verwendung von Bloch- Simulationstechniken - handhabbar.

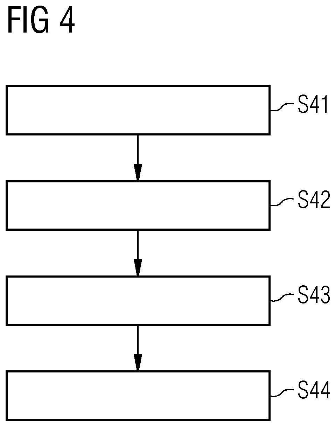

In Figur 4 werden die wesentlichen Schritte der oben beschriebenen Verfahren nochmal zusammengefasst. In einem Schritt S41 erfolgt das Aufnehmen der mehreren Diffusionsmessungen, wobei jede Diffusionsmessung einen definierten Satz von MR-Parametern aufweist und wobei in jeder Diffusionsmessung ein Parameter des MR-Datensatzes verändert wird, beispielsweise die Diffusionswichtung b wie oben beschrieben. In einem weiteren Schritt S42 werden die vielen verschiedenen berechneten Datensätze bestimmt wie sie beispielsweise in Figur drei in Tabelle 34 und 31 angegeben sind. Für jeden quantifizierten Wert der Modellparameter und für jede Kombination der Modellparameter werden für die unterschiedlichen Diffusionsmessungen Signalintensitäten berechnet, was zu den berechneten Datensätzen führt wie sie in Tabelle 34 angegeben sind. In einem Schritt S43 werden die gemessenen MR-Signale, d.h. der MR-Signaldatensatz mit der Vielzahl der berechneten Datensätze verglichen zur Identifizierung des berechneten Datensatzes mit der größten Übereinstimmung. In einem Schritt S44 kann dann der gewünschte Diffusionsparameter bestimmt werden, wobei sich dieser aus den Modellparametern ergibt, die bei dem berechneten Datensatz mit der größten Übereinstimmung verwendet wurden.

Bei den oben beschriebenen Modellparametern lagen diese auf einem äquidistanten Raster. Die Modellparameter könnten jedoch auch auf einem nicht äquidistanten Raster liegen. Beispielsweise können für größere Parameterwerte größere Abstände zwischen den einzelnen Werten der Modellparameter verwendet werden oder es kann eine logarithmische Inkrementierung der Parameterwerte erfolgen, so dass die relative Genauigkeit jedoch erhalten bleibt.

Es ist möglich, den MR-Signaldatensatz und die berechneten Datensätze zu normieren, womit beispielsweise der Modellparameter $M_0$ entfällt. Hierfür sollten die Messdaten ebenfalls entsprechend normiert werden. In einigen Fällen genügt eine Aufnahme ohne Diffusionswichtung als Referenz, auf die alle anderen Aufnahmen normiert werden. Werden bei den Diffusionsmessungen unterschiedliche Echozeiten TE verwendet kann beispielsweise für jede Echozeit eine Referenzmessung ohne Diffusionswichtung durchgeführt werden und zur Normierung verwendet werden.

Die berechneten Datensätze können für ein vorgegebenes Modell und einen definierten Satz von MR-Parametern vorberechnet sein und im Speicher liegen. Dies bietet sich insbesondere bei komplexeren Modellen an, bei denen die Berechnung der einzelnen Signaldatensätze relativ lang dauert.

Alternativ hierzu ist es möglich, die berechneten Datensätze bei der Verwendung, sozusagen "on the fly" zu berechnen. Dieses Vorgehen ist bei einfachen Modellen in der Regel ausreichend schnell und hat den Vorteil, dass flexibler auf Änderungen der MR-Parameter bei den Diffusionsmessungen, wie beispielsweise eine andere Auswahl der b-Werte oder Diffusionsrichtungen reagiert werden kann.

Als Grundlage des oben beschriebenen Verfahrens können konventionell aufgenommene diffusionsgewichtete MR-Bilder verwendet werden. Je nach verwendetem Modell können die Werte der Modellparameter auf relevante Wertebereich eingeschränkt werden, indem beispielsweise spezielle Eigenschaften des verwendeten Modells ausgenutzt werden. Beispielsweise ist es bei Verwendung des dritten Beispiels möglich, die speziellen Diffusionstensoreigenschaften auszunutzen. Das Tensorprodukt aus der b-Matrix und dem Diffusionstensor beschreibt eine lineare quadratische Form mit positiv definierter symmetrischer Matrix D.

Die b-Matrix ist dargestellt als $B_i = b_i * g_i \, g_i{}^T$. d.h. $B_i : D$ kann auch geschrieben werden als $b_i \, g_i{}^T D \, g_i$. Somit kann D mittels einer Rotationsmatrix R diagonalisiert werden so dass $D = R^T \, D' \, R$ und D' diagonal und $D'_{xx} >= D'_{yy} >= D'_{zz}$. d.h. die potentiell möglichen Werte von D sind durch die drei Diagonalelemente von D' und die Anwendung von Rotationsmatrizen bestimmt. Somit kann der Prozess der Simulation der Tensoren durch die Simulation von verschiedenen Diagonalelemente und der anschließenden Anwendung von Rotationen realisiert werden.

Da die Daten des berechneten Datensatzes und das Mapping von simulierten Messdaten auf Modellparameter vorab vorliegen, können diese als Trainingsdaten für ein lernendes Verfahren, z.B. ein künstliches Neuronales Netz (ANN) verwendet werden, um so auf Basis der Messdaten die Modellparameter implizit zu schätzen. Hierbei hat ein ANN so viele Eingangsknoten wie simulierte Messdatenpunkte. Die Ausgangsknoten des Netzwerkes realisieren die Modelparameter. Je nach verwendeter Netzarchitektur und Lernregeln können unterschiedliche Anzahlen und Topologien von versteckten Knoten zum Einsatz kommen.

**Patentansprüche**

1.  Verfahren zur Bestimmung von zumindest einem Diffusionsparameter bei einer Untersuchungsperson (13) mit Verwendung von MR-Signalen, mit den folgenden Schritten:

    - Aufnehmen von MR-Signalen in mehreren Diffusionsmessungen, wobei jede Diffusionsmessung mit einem definierten Satz von MR-Parametern gemessen wird, wobei sich die mehreren Diffusionsmessungen untereinander in zumindest einem MR-Parameter unterscheiden, wodurch ein gemessener MR-Signaldatensatz gebildet wird, der die MR-Signale für die unterschiedlichen verwendeten MR-Parameter aufweist, wobei aus den MR-Signalen mehrere MR-Diffusionsbilder erzeugt werden, bei denen die Signalintensität im zeitlichen Verlauf in einzelnen Bildpunkten der MR-Diffusionsbilder betrachtet werden zur Erstellung eines gemessenen MR-Signaldatenvektors(36a - 36d) für jeden Bildpunkt, wobei der gemessene MR-Signaldatenvektor die gemessenen Signalintensitäten für die unterschiedlichen verwendeten MR-Parameter aufweist, die bei den verschiedenen Diffusionsmessungen verwendet wurden,
    - Bestimmen einer Vielzahl von berechneten Datensätzen anhand eines gegebenen Diffusionsmodells, wobei das Diffusionsmodel die Entwicklung der MR-Signale für die durchgeführten Diffusionsmessungen beschreibt und für alle berechneten Datensätze eine definierte Anzahl von verschiedenen Modellparametern verwendet wird, wobei für verschiedene Werte der Modellparameter und jede Kombination der verschiedenen Modellparameterwerte eine berechnete MR-Signalintensität für die Diffusionsmessungen vorliegt,

- Vergleichen des gemessenen MR-Signaldatensatzes mit der Vielzahl der berechneten Datensätze zur Identifizierung desjenigen berechneten Datensatzes der auf Grundlage eines Gütekriteriums die größte Übereinstimmung mit dem gemessenen MR-Signaldatensatz aufweist,

- Bestimmen des zumindest einen Diffusionsparameters anhand des berechneten Datensatzes mit der größten Übereinstimmung, wobei der zumindest eine Diffusionsparameter aus den Modellparametern bestimmt wird, die bei der Bestimmung des berechneten Datensatzes mit der größten Übereinstimmung verwendet wurden, **dadurch gekennzeichnet, dass** bei den mehreren Diffusionsmessungen jeweils der zugehörige Rohdatenraum gemäß der Nyquist Bedingung vollständig abgetastet wird.

2. Verfahren nach Anspruch 1, **dadurch gekennzeichnet, dass** N Diffusionsmessungen durchgeführt werden mit N unterschiedlichen Sätzen der MR-Parameter, wobei für eine festgelegte Kombination der Modellparameter für die N Sätze der MR-Parameter die Signalintensität berechnet wird zur Erstellung von einem berechneten Datenvektor (34a, 34b) für diese festgelegte Kombination der Modellparameter und den verwendeten N Werten der MR-Parameter, wobei der berechnete Datenvektor (34a, 34b) für alle möglichen Kombinationen der Werte der Modellparameter bestimmt wird zur Bestimmung von einer Vielzahl von unterschiedlichen berechneten Datenvektoren, wobei jeder berechnete Datenvektor (34a, 34b) die MR-Signalintensitäten für die N Diffusionsmessungen bei Verwendung der festgelegten Kombination der Modellparameter aufweist.

3. Verfahren nach Anspruch 2, **dadurch gekennzeichnet, dass** bei der Identifizierung desjenigen berechneten Datensatzes, der die größte Übereinstimmung mit dem gemessenen MR-Signaldatensatz aufweist, der gemessene MR-Signaldatenvektor (36a - 36d) mit der Vielzahl von unterschiedlichen berechneten Datenvektoren verglichen wird und der berechnete Datenvektor bestimmt wird, der die größte Übereinstimmung mit dem gemessenen MR-Signaldatenvektor (36a - 36d) hat.

4. Verfahren nach einem der vorstehenden Ansprüche, **dadurch gekennzeichnet, dass** sowohl der gemessene MR-Signaldatensatz als auch die Vielzahl der berechneten Datensätze normiert werden vor dem Vergleichen.

5. Verfahren nach einem der vorstehenden Ansprüche, **dadurch gekennzeichnet, dass** bei der Aufnahme der mehreren Diffusionsmessungen zumindest unterschiedliche Diffusionswichtungen als unterschiedliche MR-Parameter verwendet werden, wobei für jede Diffusionswichtung und die möglichen Kombinationen der verschiedenen Werte der verschiedenen Modellparameter die MR-Signalintensität berechnet wird.

6. Verfahren nach einem der vorstehenden Ansprüche, **dadurch gekennzeichnet, dass** die verschiedenen Modellparameter zumindest einen der folgenden Modellparameter aufweisen: die Magnetisierung $M_0$, die sich ohne Diffusionswichtung ergibt, den apparenten Diffusionskoeffizient, ADC, und den Diffusionstensor.

7. Verfahren nach einem der vorstehenden Ansprüche, **dadurch gekennzeichnet, dass** die verschiedenen Modellparameter einen Diffusionstensor aufweisen, wobei bei den Diffusionmessungen zumindest 3 verschiedene Diffusionsmessungen entlang unterschiedlicher Diffusionsrichtungen, die aufeinander senkrecht stehen durchgeführt werden.

8. Verfahren nach Anspruch 7, **dadurch gekennzeichnet, dass** als Modellparameter die Magnetisierung $M_0$, die sich ohne Diffusionswichtung ergibt, und 6 Komponenten des Diffusionstensors verwendet werden, wobei bei dem berechneten Datensatz mit der größten Ähnlichkeit die Spur des Diffusionstensors verwendet wird zur Bestimmung einer mittleren richtungsunabhängigen Diffusion als Diffusionsparameter.

9. Verfahren nach Anspruch 7, **dadurch gekennzeichnet, dass** als Modellparameter die Magnetisierung $M_0$, die sich ohne Diffusionswichtung ergibt, und 6 Komponenten des Diffusionstensors verwendet werden, wobei Diffusionsmessungen mit zumindest 2 verschiedenen Diffusionswichtungen und zumindest 6 verschiedenen Diffusionsrichtungen durchgeführt werden, wobei bei dem berechneten Datensatz mit der größten Ähnlichkeit alle Tensorkomponenten des Diffusionstensors bestimmt werden zur Bestimmung eines Diffusionstensors als Diffusionsparameter.

10. Magnetresonanzanlage (10), die ausgebildet ist, zur Bestimmung von zumindest einem Diffusionsparameter bei einer Untersuchungsperson (13), wobei die MR-Anlage eine Steuereinheit (20) und eine Speichereinheit (21) aufweist, wobei die Speichereinheit (21) von der Steuereinheit (20) ausführbare Steuerinformationen speichert, wobei die MR-Anlage ausgebildet ist, bei Ausführung der Steuerinformationen in der Steuereinheit folgende Schritte auszuführen:

- Aufnehmen von MR-Signalen in mehreren Diffusionsmessungen, wobei jede Diffusionsmessung mit einem definierten Satz von MR-Parametern gemessen wird, wobei sich die mehreren Diffusionsmessungen untereinander in zumindest einem MR-Parameter unterscheiden, wodurch ein gemessener MR-Signaldatensatz gebildet wird, der die MR-Signale für die unterschiedlichen verwendeten MR-Parameter aufweist, wobei aus den MR-Signalen mehrere MR-Diffusionsbilder erzeugt werden, bei denen die Signalintensität im zeitlichen Verlauf in einzelnen Bildpunkten der MR-Diffusionsbilder betrachtet werden zur Erstellung eines gemessenen MR-Signaldatenvektors(36a - 36d) für jeden Bildpunkt, wobei der gemessene MR-Signaldatenvektor die gemessenen Signalintensitäten für die unterschiedlichen verwendeten MR-Parameter aufweist, die bei den verschiedenen Diffusionsmessungen verwendet wurden,
- Bestimmen einer Vielzahl von berechneten Datensätzen anhand eines gegebenen Diffusionsmodells, wobei das Diffusionsmodell die Entwicklung der MR-Signale für die durchgeführten Diffusionsmessungen beschreibt und für alle berechneten Datensätze eine definierte Anzahl von verschiedenen Modellparametern verwendet wird, wobei für verschiedene Werte der Modellparameter und jede Kombination der verschiedenen Modellparameterwerte eine berechnete MR-Signalintensität für die Diffusionsmessungen vorliegt,
- Vergleichen des gemessenen MR-Signaldatensatzes mit der Vielzahl der berechneten Datensätze zur Identifizierung desjenigen berechneten Datensatzes der auf Grundlage eines Gütekriteriums die größte Übereinstimmung mit dem gemessenen MR-Signaldatensatz aufweist,
- Bestimmen des zumindest einen Diffusionsparameters anhand des berechneten Datensatzes mit der größten Übereinstimmung, wobei der zumindest eine Diffusionsparameter aus den Modellparametern bestimmt wird, die bei der Bestimmung des berechneten Datensatzes mit der größten Übereinstimmung verwendet wurden, **dadurch gekennzeichnet, dass** bei den mehreren Diffusionsmessungen jeweils der zugehörige Rohdatenraum gemäß der Nyquist Bedingung vollständig abgetastet wird.

11. MR-Anlage nach Anspruch 10, **dadurch gekennzeichnet, dass** die MR-Anlage ausgebildet ist bei Ausführung der Steuerinformationen in der Steuereinheit ein Verfahren nach einem der Ansprüche 2 bis 9 auszuführen.

12. Computerprogrammprodukt, welches Programmmittel umfasst und direkt in eine Speichereinheit einer Steuereinheit einer MR-Anlage ladbar ist, um alle Schritte des Verfahrens nach einem der Ansprüche 1-9 auszuführen, wenn die Programmmittel in der Steuereinrichtung ausgeführt werden.

13. Elektronisch lesbarer Datenträger mit darauf gespeicherten elektronisch lesbaren Steuerinformationen, welche derart ausgestaltet sind, dass sie bei Verwendung des Datenträgers in einer Steuereinheit einer MR-Anlage das Verfahren nach einem der Ansprüche 1-9 durchführen.

**Claims**

1. Method for determining at least one diffusion parameter for a person under examination (13) using MR signals, comprising the following steps:

- acquiring MR signals in a plurality of diffusion measurements, wherein each diffusion measurement is measured using a defined set of MR parameters, wherein the plurality of diffusion measurements differ amongst each other in terms of at least one MR parameter, thereby creating a measured MR-signal dataset, which comprises the MR signals for the different MR parameters used, wherein a plurality of MR diffusion images are generated from the MR signals, for which images the signal intensity over time in the individual pixels of the MR diffusion images is considered in order to create a measured MR-signal data vector (36a - 36d) for each pixel, wherein the measured MR-signal data vector comprises the measured signal intensities for the different MR parameters used, which were employed in the various diffusion measurements;
- determining a multiplicity of calculated datasets using a predetermined diffusion model, wherein the diffusion model describes the change in the MR signals for the diffusion measurements carried out, and a defined number of different model parameters is used for all the calculated datasets, wherein for different values of the model parameters and each combination of the different model parameter values, there exists a calculated MR-signal intensity for the diffusion measurements;
- comparing the measured MR-signal dataset with the multiplicity of the calculated datasets in order to identify the calculated dataset that, on the basis of a quality criterion, has the closest match to the measured MR-signal dataset;

- determining the at least one diffusion parameter from the calculated dataset having the closest match, wherein the at least one diffusion parameter is determined from the model parameters that were used in determining the calculated dataset having the closest match,

**characterised in that** in the plurality of diffusion measurements, in each case the associated raw data space is fully sampled in accordance with the Nyquist condition.

2. Method according to claim 1, **characterised in that** N diffusion measurements are performed using N different sets of the MR parameters, wherein for a defined combination of the model parameters the signal intensity is calculated for the N sets of the MR parameters in order to create a calculated data vector (34a, 34b) for this defined combination of the model parameters and the N values used for the MR parameters, wherein the calculated data vector (34a, 34b) is determined for all possible combinations of the values of the model parameters in order to determine a multiplicity of different calculated data vectors, wherein each calculated data vector (34a, 34b) comprises the MR-signal intensities for the N diffusion measurements when using the defined combination of the model parameters.

3. Method according to claim 2, **characterised in that** when identifying the calculated dataset that has the closest match to the measured MR-signal dataset, the measured MR-signal data vector (36a - 36d) is compared with the multiplicity of different calculated data vectors, and the calculated data vector is determined that has the closest match to the measured MR-signal data vector (36a - 36d).

4. Method according to one of the preceding claims, **characterised in that** both the measured MR-signal dataset and the multiplicity of the calculated datasets are normalised before the comparison.

5. Method according to one of the preceding claims, **characterised in that** during the acquisition of the plurality of diffusion measurements, at least different diffusion weightings are used as the different MR parameters, wherein the MR-signal intensity is calculated for each diffusion weighting and the possible combinations of the different values of the different model parameters.

6. Method according to one of the preceding claims, **characterised in that** the different model parameters comprise at least one of the following model parameters: the magnetisation $M_0$ that is produced without diffusion weighting, the apparent diffusion coefficient, ADC, and the diffusion tensor.

7. Method according to one of the preceding claims, **characterised in that** the different model parameters comprise a diffusion tensor, wherein for the diffusion measurements at least 3 different diffusion measurements are performed using different mutually orthogonal diffusion directions.

8. Method according to claim 7, **characterised in that** the magnetisation $M_0$ that is produced without diffusion weighting and 6 components of the diffusion tensor are used as the model parameters, wherein for the calculated dataset having the greatest similarity, the trace of the diffusion tensor is used to determine a mean isotropic diffusion as the diffusion parameter.

9. Method according to claim 7, **characterised in that** the magnetisation $M_0$ that is produced without diffusion weighting and 6 components of the diffusion tensor are used as the model parameters, wherein diffusion measurements are performed using at least 2 different diffusion weightings and at least 6 different diffusion directions, wherein for the calculated dataset having the greatest similarity, all the tensor components of the diffusion tensor are determined in order to determine a diffusion tensor as the diffusion parameter.

10. Magnetic resonance machine (10), which is designed to determine at least one diffusion parameter for a person under examination (13), wherein the MR machine comprises a control unit (20) and a memory unit (21), wherein the memory unit (21) stores control information that can be executed by the control unit (20), wherein the MR machine is designed to perform the following steps when the control information is executed in the control unit:

- acquiring MR signals in a plurality of diffusion measurements, wherein each diffusion measurement is measured using a defined set of MR parameters, wherein the plurality of diffusion measurements differ amongst each other in terms of at least one MR parameter, thereby creating a measured MR-signal dataset, which comprises the MR signals for the different MR parameters used, wherein a plurality of MR diffusion images are generated from the MR signals, for which images the signal intensity over time in the individual pixels of the MR diffusion images is considered in order to create a measured MR-signal data vector (36a - 36d) for each pixel, wherein the measured MR-signal data vector comprises the measured signal intensities for the different MR parameters used, which were employed in the various diffusion measurements;

- determining a multiplicity of calculated datasets using a predetermined diffusion model, wherein the diffusion model describes the change in the MR signals for the diffusion measurements carried out, and a defined number of different model parameters is used for all the calculated datasets, wherein for different values of the model parameters and each combination of the different model parameter values, there exists a calculated MR-signal intensity for the diffusion measurements;

- comparing the measured MR-signal dataset with the multiplicity of the calculated datasets in order to identify the calculated dataset that, on the basis of a quality criterion, has the closest match to the measured MR-signal dataset;

- determining the at least one diffusion parameter from the calculated dataset having the closest match, wherein the at least one diffusion parameter is determined from the model parameters that were used in determining the calculated dataset having the closest match,

**characterised in that** in the plurality of diffusion measurements, in each case the associated raw data space is fully sampled in accordance with the Nyquist condition.

11. MR machine according to claim 10, **characterised in that** the MR machine is designed to perform a method according to one of claims 2 to 9 when the control information is executed in the control unit.

12. Computer program product which comprises program means and can be loaded directly into a memory unit of a control unit of an MR machine in order to perform all the steps of the method according to one of claims 1 to 9 when the program means are executed in the control device.

13. Electronically readable data storage medium comprising electronically readable control information stored thereon, which information is designed such that it performs the method according to one of claims 1 to 9 when the data storage medium is used in a control unit of an MR machine.

## Revendications

1. Procédé de détermination d'au moins un paramètre de diffusion chez une personne (13) à examiner par utilisation de signaux RM, comprenant les stades suivants :

- enregistrement de signaux RM en plusieurs mesures de diffusion, dans lequel on mesure chaque mesure de diffusion par un ensemble défini de paramètres RM, les plusieurs mesures de diffusion étant différentes les unes des autres par au moins un paramètre RM, grâce à quoi on forme un ensemble de données de signal RM mesuré, qui a les signaux RM pour les différents paramètres RM utilisés, dans lequel on produit, à partir des signaux RM, plusieurs images de diffusion RM, dans lesquelles l'intensité du signal au cours du temps dans divers points image des images de diffusion RM est prise en considération pour l'établissement d'un vecteur (36a - 36d) de données de signal RM mesuré pour chaque point image, le vecteur de données de signal RM mesuré ayant les intensités du signal mesuré pour les différents paramètres RM utilisés, qui ont été utilisés lors des différentes mesures de diffusion,

- détermination d'une pluralité d'ensembles de données calculés à l'aide d'un modèle de diffusion donné, le modèle de diffusion décrivant le développement des signaux RM pour les mesures de diffusion effectuées et on utilise, pour tous les jeux de données calculés, un nombre défini de paramètres de modèle différents, dans lequel, pour des valeurs différentes des paramètres de modèle et pour chaque combinaison des différentes valeurs de paramètres de modèle, il y a une intensité du signal RM calculée pour les mesures de diffusion,

- comparaison de l'ensemble de données de signal RM mesuré à la pluralité des ensembles de données calculés pour l'identification de l'ensemble de données calculé, qui, sur la base d'un critère de qualité, coïncide le mieux avec l'ensemble de données de signal RM mesuré,

- détermination du au moins un paramètre de diffusion à l'aide de l'ensemble de données calculé coïncidant le mieux, le au moins un paramètre de diffusion étant déterminé à partir des paramètres du modèle, qui ont été utilisés lors de la détermination de l'ensemble de données calculé, qui coïncide le mieux,

**caractérisé en ce que**, pour les plusieurs mesures de diffusion, on balaie complètement, respectivement, l'espace de données brut associé suivant la condition de Nyquist.

2. Procédé suivant la revendication 1, **caractérisé en ce que** l'on effectue N mesures de diffusion avec N ensembles différents des paramètres RM, dans lequel, pour une combinaison fixée des paramètres de modèle, on calcule, pour les N ensembles des paramètres RM, l'intensité du signal pour l'établissement d'un vecteur (34a, 34b) de données calculé pour cette combinaison fixée des paramètres de modèle et les N valeurs utilisées des paramètres RM, le vecteur (34a, 34b) de données calculé étant déterminé pour toutes les combinaison possibles des valeurs des paramètres du modèle, afin de déterminer une pluralité de vecteurs de données calculés différents, chaque vecteur (34a, 34b) de données calculé ayant les intensités du signal RM pour les N mesures de diffusion, lors de l'utilisation de la combinaison fixée des paramètres du modèle.

3. Procédé suivant la revendication 2, **caractérisé en ce que**, lors de l'identification de l'ensemble de données calculé, qui coïncide le mieux avec l'ensemble de données de signal RM mesuré, on détermine le vecteur (36a - 36d) de données de signal RM mesuré ayant la pluralité de vecteurs de données calculés différents et on détermine le vecteur de données calculé, qui coïncide le mieux avec le vecteur (36a - 36d) de données de signal RM mesuré.

4. Procédé suivant l'une des revendications précédentes, **caractérisé en ce que** l'on norme à la fois l'ensemble de données de signal RM mesuré et la pluralité d'ensembles de données calculés avant la comparaison.

5. Procédé suivant l'une des revendications précédentes, **caractérisé en ce que**, lors de l'enregistrement des plusieurs mesures de diffusion, on utilise au moins des pondérations de diffusion différentes comme paramètres RM différents, dans lequel on calcule l'intensité du signal RM pour chaque pondération de diffusion et les combinaisons possibles des valeurs différentes des paramètres du modèle différents.

6. Procédé suivant l'une des revendications précédentes, **caractérisé en ce que** les différents paramètres du modèle ont au moins l'un des paramètres du modèle suivant : l'aimantation $M_0$, que l'on obtient sans pondération de diffusion, le coefficient de diffusion apparente, ADC, et le tenseur de diffusion.

7. Procédé suivant l'une des revendications précédentes, **caractérisé en ce que** les paramètres de modèle différents ont un tenseur de diffusion, dans lequel, lors des mesures de diffusion, on effectue au moins 3 mesures de diffusion différentes suivant des directions de diffusion différentes, qui sont perpendiculaires entre elles.

8. Procédé suivant la revendication 7, **caractérisé en ce que** l'on utilise comme paramètre du modèle, l'aimantation $M_0$, que l'on obtient sans pondération de diffusion et 6 composantes du tenseur de diffusion, dans lequel, pour l'ensemble de données calculé, ayant la similitude la plus grande, on utilise la trace du tenseur de diffusion pour la détermination d'une diffusion moyenne indépendante de la direction comme paramètre de diffusion.

9. Procédé suivant la revendication 7, **caractérisé en ce que** l'on utilise comme paramètre du modèle l'aimantation $M_0$, que l'on obtient sans pondération de diffusion et 6 composantes du tenseur de diffusion, dans lequel on effectue des mesures de diffusion avec au moins 2 pondérations de diffusion différentes et au moins 6 directions de diffusion différentes, dans lequel, pour l'ensemble de données calculé, ayant la plus grande similitude, on détermine toutes les composantes du tenseur de diffusion pour la détermination d'un tenseur de diffusion comme paramètre de diffusion.

10. Installation (10) de résonnance magnétique, constituée pour la détermination d'au moins un paramètre de diffusion chez une personne (13) à examiner, l'installation RM ayant une unité (20) de commande et une unité (21) de mise en mémoire, l'unité (21) de mise en mémoire mettant en mémoire des informations de commande pouvant être réalisées par l'unité (20) de commande, l'installation RM étant constituée pour exécuter, lors de la réalisation des informations de commande dans l'unité de commande, les stades suivants :

- enregistrement de signaux RM en plusieurs mesures de diffusion, dans lequel on mesure chaque mesure de diffusion par un ensemble défini de paramètres RM, les plusieurs mesures de diffusion étant différentes les unes des autres par au moins un paramètre RM, grâce à quoi on forme un ensemble de données de signal RM mesuré, qui a les signaux RM pour les différents paramètres RM utilisés, dans lequel on produit, à partir des signaux RM, plusieurs images de diffusion RM, dans lesquelles l'intensité du signal au cours du temps dans divers points image des images de diffusion RM est prise en considération pour l'établissement d'un vecteur (36a - 36d) de données de signal RM mesuré pour chaque point image, le vecteur de données de signal RM mesuré ayant les intensités du signal mesuré pour les différents paramètres RM utilisés, qui ont été utilisés lors des différentes mesures de diffusion,
- détermination d'une pluralité d'ensembles de données calculés à l'aide d'un modèle de diffusion donné, le modèle de diffusion décrivant le développement des signaux RM pour les mesures de diffusion effectuées et on utilise, pour tous les jeux de données calculés, un nombre défini de paramètres de modèle différents, dans lequel, pour des valeurs différentes des paramètres de modèle et pour chaque combinaison des différentes valeurs de paramètres de modèle, il y a une intensité du signal RM calculée pour les mesure de diffusion,

- comparaison de l'ensemble de données de signal RM mesuré à la pluralité des ensembles de données calculés pour l'identification de l'ensemble de données calculé, qui, sur la base d'un critère de qualité, coïncide le mieux avec l'ensemble de données de signal RM mesuré,

- détermination du au moins un paramètre de diffusion à l'aide de l'ensemble de données calculé coïncidant le mieux, le au moins un paramètre de diffusion étant déterminé à partir des paramètres du modèle, qui ont été utilisés lors de la détermination de l'ensemble de données calculé, qui coïncide le mieux,

**caractérisé en ce que**, pour les plusieurs mesures de diffusion, on balaie complètement, respectivement, l'espace de données brut associé suivant la condition de Nyquist.

11. Installation RM suivant la revendication 10, **caractérisée en ce que** l'installation RM est constituée pour exécuter, lors de l'exécution des informations de commande dans l'unité de commande, un procédé suivant l'une des revendications 2 à 9.

12. Produit de programme d'ordinateur, qui comprend des moyens de programme et qui peut être chargé directement dans une unité de mise en mémoire d'une unité de commande d'une installation RM pour effectuer tous les stades du procédé suivant l'une des revendications 1 à 9, lorsque les moyens de programme sont réalisés dans le dispositif de commande.

13. Support de données déchiffrables électroniquement, sur lequel sont mises en mémoire des informations de commande déchiffrables électroniquement, qui sont conformées de manière à ce qu'elles effectuent le procédé suivant l'une des revendications 1 à 9 lors d'une utilisation du support de données dans une unité de commande d'une installation RM.

FIG 1

FIG 2

# FIG 3

| FIG 3A | FIG 3B |
|---|---|
|  |  |

## FIG 3A

31  32  33  34

$$S'=M0*\exp(-b*ADC)$$

| | M0 | ADC | b0 0 | b1 1000 | b2 2000 |
|---|---|---|---|---|---|
| 0 | 0 | 0 | 0 | 0 | 0 |
| 1 | 1000 | 0 | 1000 | 1000 | 1000 |
| 2 | 1000 | 1 | 1000 | 367,8794 | 135,3353 |
| 3 | 1000 | 2 | 1000 | 135,3353 | 18,31564 |
| 4 | 1000 | 3 | 1000 | 49,78707 | 2,478752 |
| 5 | 1000 | 4 | 1000 | 18,31564 | 0,335463 |
| 6 | 2000 | 0 | 2000 | 2000 | 2000 |
| 7 | 2000 | 1 | 2000 | 735,7589 | 270,6706 |
| 8 | 2000 | 2 | 2000 | 270,6706 | 36,63128 |
| 9 | 2000 | 3 | 2000 | 99,57414 | 4,957504 |
| 10 | 2000 | 4 | 2000 | 36,63128 | 0,670925 |
| 11 | 3000 | 0 | 3000 | 3000 | 3000 |
| 12 | 3000 | 1 | 3000 | 1103,638 | 406,0058 |
| 13 | 3000 | 2 | 3000 | 406,0058 | 54,94692 |
| 14 | 3000 | 3 | 3000 | 149,3612 | 7,436257 |
| 15 | 3000 | 4 | 3000 | 54,94692 | 1,006388 |
| 16 | 4000 | 0 | 4000 | 4000 | 4000 |
| 17 | 4000 | 1 | 4000 | 1471,518 | 541,3411 |
| 18 | 4000 | 2 | 4000 | 541,3411 | 73,26256 |
| 19 | 4000 | 3 | 4000 | 199,1483 | 9,915009 |
| 20 | 5000 | 0 | 5000 | 5000 | 5000 |
| 21 | 5000 | 1 | 5000 | 1839,397 | 676,6764 |
| 22 | 5000 | 2 | 5000 | 676,6764 | 91,57819 |
| 23 | 5000 | 3 | 5000 | 248,9353 | 12,39376 |
| 24 | 5000 | 4 | 5000 | 91,57819 | 1,677313 |

34a
34b

# FIG 3B

| | 36a | 36b | 36c | 36d | 35 |
|---|---|---|---|---|---|
| b=0 | 1000 | 2100 | 1200 | 3100 | |
| b=1000 | 1000 | 105 | 200 | 70 | |
| b=2000 | 1000 | 7 | 80 | 0 | |

| 38a | 38b | 38c | 38d | 37 |
|---|---|---|---|---|
| 1732,051 | 2102,635 | 1219,180 | 3100,790 | |
| 0,000 | 1731,20594 | 1235,476 | 2504,975 | |
| 1071,084 | 1138,234 | 266,919 | 2125,335 | |
| 1308,185 | 1100,476 | 219,058 | 2101,096 | |
| 1377,662 | 1101,394 | 261,865 | 2100,099 | |
| 1401,083 | 1103,430 | 281,701 | 2100,636 | |
| 1732,051 | 2751,922 | 2750,709 | 2989,130 | |
| 1265,601 | 690,926 | 981,526 | 1313,962 | |
| 1568,439 | 195,767 | 804,286 | 1118,754 | |
| 1673,582 | 100,168 | 809,763 | 1100,409 | |
| 1710,771 | 121,303 | 820,355 | 1100,506 | |
| 3464,102 | 4260,173 | 4427,911 | 4194,628 | |
| 2088,916 | 1402,314 | 2040,304 | 1115,011 | |
| 2290,405 | 950,212 | 1811,923 | 354,851 | |
| 2389,303 | 901,093 | 1802,174 | 127,881 | |
| 2427,162 | 901,411 | 1807,562 | 101,132 | |
| 5196,152 | 5892,798 | 6135,666 | 5679,340 | |
| 3071,270 | 2400,602 | 3109,597 | 1751,372 | |
| 3173,202 | 1950,586 | 2820,737 | 1018,592 | |
| 3259,084 | 1902,333 | 2800,877 | 909,273 | |
| 6928,203 | 7569,747 | 7854,069 | 7274,263 | |
| 4099,893 | 3444,793 | 4181,345 | 2683,031 | |
| 4114,580 | 2957,020 | 3829,798 | 1996,608 | |
| 4188,014 | 2903,575 | 3800,916 | 1908,447 | |
| 4221,597 | 2900,036 | 3802,353 | 1900,123 | |

| | | | | | 39 |
|---|---|---|---|---|---|
| M0 | 1000 | 2000 | 1000 | 3000 | |
| ADC | 0 | 3 | 2 | 4 | |

# FIG 4

```
┌─────────────────────────────────┐
│                                 │──S41
└─────────────────────────────────┘
                  │
                  ▼
┌─────────────────────────────────┐
│                                 │──S42
└─────────────────────────────────┘
                  │
                  ▼
┌─────────────────────────────────┐
│                                 │──S43
└─────────────────────────────────┘
                  │
                  ▼
┌─────────────────────────────────┐
│                                 │──S44
└─────────────────────────────────┘
```

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- Simultaneous TI, T2 and Diffusion Quantification using Multiple Contrast Prepared Magnetic Resonance Fingerprinting. **YUN JIANG et al.** PROCEEDINGS OF THE INTERNATIONAL SOCIETY FOR MAGNETIC RESONANCE IN MEDICINE, ISMRM, 25TH ANNUAL MEETING AND EXHIBITION. HONOLULU, 07. April 2017, 1171